Europäisches Patentamt

European Patent Office

Office européen des brevets

(19)

(11) Publication number: **0 400 483**
**A2**

## EUROPEAN PATENT APPLICATION

(21) Application number: **90109893.9**

(22) Date of filing: **23.05.90**

(30) Priority: **23.05.89 JP 129948/89**

(43) Date of publication of application:
**05.12.90 Bulletin 90/49**

(84) Designated Contracting States:
**DE FR GB**

(51) Int. Cl.⁵: **G11C 16/02**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Naruke, Kiyomi, 206,**
**High-Town-Takashimacho**
**119-2, Tobe-Cho 4-Chome, Nishi-Ku**
**Yokohama-Shi, Kanagawa-Ken(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) **Programming method for semiconductor memory device.**

㊿ There is disclosed an improvement in a programming method in a semiconductor memory device for injecting electrons into a floating gate (3) and extracting them through a tunnel portion (3a). In acoordance with this programming method, a program voltage is applied across the drain (1) and the control gate (4) of each memory cell from which electrons are extracted, and a voltage having the same polarity as that of the program voltage and an absolute value which is small to such an extent that field inversion can be prevented is applied across the drain (1) and the control gate (4) of each memory cell from which no electron is extracted.

F I G. 5

EP 0 400 483 A2

## BACKGROUND OF THE INVENTION

This invention relates to a programming method for a semiconductor memory device.

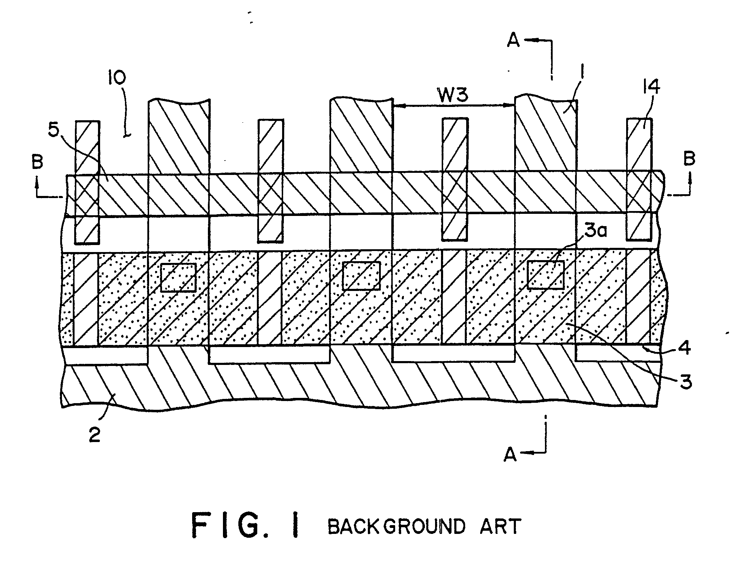

A conventional programming method for a semiconductor memory device will be described with reference to the attached drawings. FIG. 1 is a plan view showing an EEPROM using a MOS FET of the floating gate type as a memory cell.

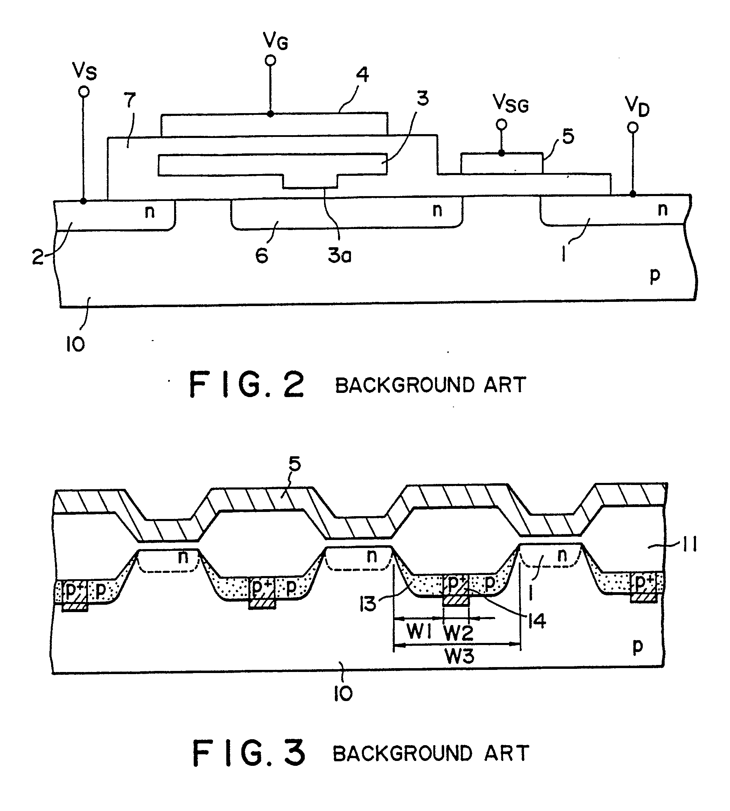

A plurality of drains 1 each comprised of an n-type impurity layer are arranged on a p-type semiconductor substrate 10, respectively, and p-type impurity layers of high concentration each serving as a field inversion preventive layer are provided between drains 1. Above these impurity layers 14, a select gate 5 is provided. Furthermore, between respective drains 1 and a common source 2, floating gates 3 (portions indicated by dots) and control gates 4 (whose portions are shown by hatching lines) thereabove are provided. The A-A cross section of this structure is shown in FIG. 2. An n-type impurity layer 6 is formed between the drain 1 and the source 2. The above-mentioned control gate 4 is provided through an interlayer insulating film 7 is provided above the impurity layer 6. In addition, the above-mentioned floating gate 3 is buried within the interlayer insulating film 7. The interlayer insulating film 7 is provided with a tunnel window 3a. This tunnel window 3a results in provision of a thin insulating film between the floating gate 3 and the impurity layer 6 to thereby carry out electron injection into the floating gate 3 and electron extraction from the floating gate 3 by making use of the tunnel effect of electrons. Above a region between the impurity layer 6 and the drain 1, the above-mentioned select gate 5 is provided.

In the semiconductor memory device thus constructed, programming was conventionally conducted as follows.

The injection of electrons into the floating gate 3 (hereinafter referred to as "an electron injection mode") is executed by applying a program voltage, e.g., 20 volts to the control gate 4 and the select gate 5. Then the source 2 and the drain 1 are maintained at zero volts. On the other hand, in the case of extraction of electrons injected (hereinafter referred to as "an electron extraction mode), the control gate 4 is first kept at zero volts to apply a program voltage, e.g., 20 volts to the select gate 5. Then, each drain 1 of memory cells from which no electron is extracted is kept at zero volts and a program voltage is applied to each drain 1 of memory cells from which electrons are extracted.

With such a conventional programming method, however, since each drain 1 from which no electrons are extracted is kept at zero volts in the electron extraction mode, the structure described below was required for prevention of punch-through phenomenon between adjacent drains and/or the occurrence of leak currents due to field inversion.

The cross sectional view taken along the B-B line of FIG. 1 is shown in FIG. 3. Below device isolation regions 11 for isolating respective drains 1, p-type impurity layers 13 each serving as a field inversion preventive layer are formed. Further, a $p^+$ type impurity layer 14 is formed in a central region which does not adjoin each drain 1. In this structure, the impurity layer 13 has a low impurity concentration in order to obtain a higher junction withstand voltage than a program voltage. On the other hand, the impurity layer 14 has a high concentration so that punch-through and leak current due to field inversion do not occur even if a program voltage is applied to the select gate 5 as described above.

In this case, a sufficient width W1 of more than 1.4 $\mu$m is taken in order that impurity layer 13 having a low concentration definitely exists between the drain 1 and the impurity layer 14 having a high concentration even if any shift occurs in mask alignment or injected impurities are laterally diffused in forming the respective impurity layers. Furthermore, since 1.2 $\mu$m of the limit value of the resist film opening in implanting or injecting impurity ions is required as the width W2 of the impurity layer 14 having a high concentration, the length of the impurity layer 13, i.e., the distance W3 between drains cannot be shorter than 4.0 $\mu$m, resulting in the problem that the chip area cannot be reduced and the degree of integration is not improved.

## SUMMARY OF THE INVENTION

An object of this invention is to provide a programming method for a semiconductor memory device, which is capable of effectively preventing a leak current even if the width of an impurity layer between drains is shortened, resulting in a reduced chip area and an improved degree of integration.

In accordance with this invention, there is provided a programming method for a semiconductor memory device adapted to extract electrons injected into a floating gate of a selected memory cell in a semiconductor memory device provided with two memory cells or more, each memory cell comprising a first impurity layer of a conductivity type opposite to a conductivity type of a semiconductor substrate formed on the semiconductor substrate; a second impurity layer of the opposite conductivity type formed on the surface of the semiconductor substrate with a predetermined spacing between the second and first impurity layers; a third impurity layer of the opposite conductivity type formed, with predetermined spacings between the third and first impurity layers and between the third and second impurity layers, between the first and second impurity layers, respectively; a select gate formed through an insulating film on the surface of the semiconductor substrate between the first and third impurity layers; a control gate formed through an insulating film above the third impurity layer, and a floating gate buried in the insulating layer so that it is positioned between the third impurity layer and the control gate and having a portion projected downwardly to thereby allow an insulating film portion between the floating gate and the third impurity layer to be thin and therefore form a tunnel portion, wherein a program voltage is applied across a first impurity layer portion of each memory cell from which electrons are to be extracted to the third impurity layer, and wherein a voltage having the same polarity as that of the program voltage and having an absolute value which is small to such an extent that field inversion can be prevented is applied across a first impurity layer portion of each memory cell from which no electron is extracted to the third impurity layer and the control gate.

Accordingly, by applying a voltage having the same polarity as that of the program voltage and a small absolute value to a first impurity layer portion of each memory cell from which no electron is extracted to the third impurity layer, there results in the state where a back gate bias is applied, so the punch-through withstand voltage and the field inversion voltage become high. As a result, occurrence of a leak current from the first impurity layer portion of each memory cell from which electrons of the first impurity layer are to be extracted to the third impurity layer portion of each memory cell from which no electron is extracted to the third impurity layer can be prevented without requiring the high concentration P-type impurity layer.

Thus, this makes it possible to shorten the distance between drains to attain a reduced chip area.

BRIEF DESCRIPTION OF THE DRAWINGS

In the accompanying drawings;

FIG. 1 is a plan view showing a device to which a conventional programming method for a semiconductor memory device is applied;

FIG. 2 is a cross sectional view taken along the A-A line in FIG. 1;

FIG. 3 is a cross sectional view taken along the B-B line in FIG. 1;.

FIG. 4 is a circuit diagram showing the configuration of a memory cell in a semiconductor memory device according to an embodiment of this invention;

FIG. 5 is a plan view showing a device to which a programming method for the semiconductor memory device shown in FIG. 4 is applied;

FIG. 6 is a cross sectional view taken along the B-B line in FIG. 5; and

FIG. 7 is a circuit diagram showing the configuration of another memory cell.

DESCRIPTION OF THE PREFERRED EMBODIMENT

A programming method for a semiconductor memory device according to an embodiment of this invention will be described with reference to the attached drawings.

As compared to the conventional programming method, a programming method in this embodiment differs from the conventional programming method in the way of applying a voltage in the electron extraction mode. In the case of the prior art, as described above, in FIG. 2, there was used a method in which the control gate 4 is kept at zero volts, a program voltage is applied to and the select gate 5, a program voltage is applied to the drain 1 of each memory cell from which electrons are to be extracted, and a drain 1 of each memory cell from which no electron is extracted is kept at zero volts. On the contrary, in this embodiment, the method of applying a voltage to the control gate 4, the select gate 5, and the drain 1 from which electrons are to be extracted is the same as that in the prior art. However, a voltage lower than the program voltage and having the same polarity as that program voltage, and having a value sufficient to prevent tunneling e.g., about 1.5 volts is applied to the drain 1 from which no electron is extracted.

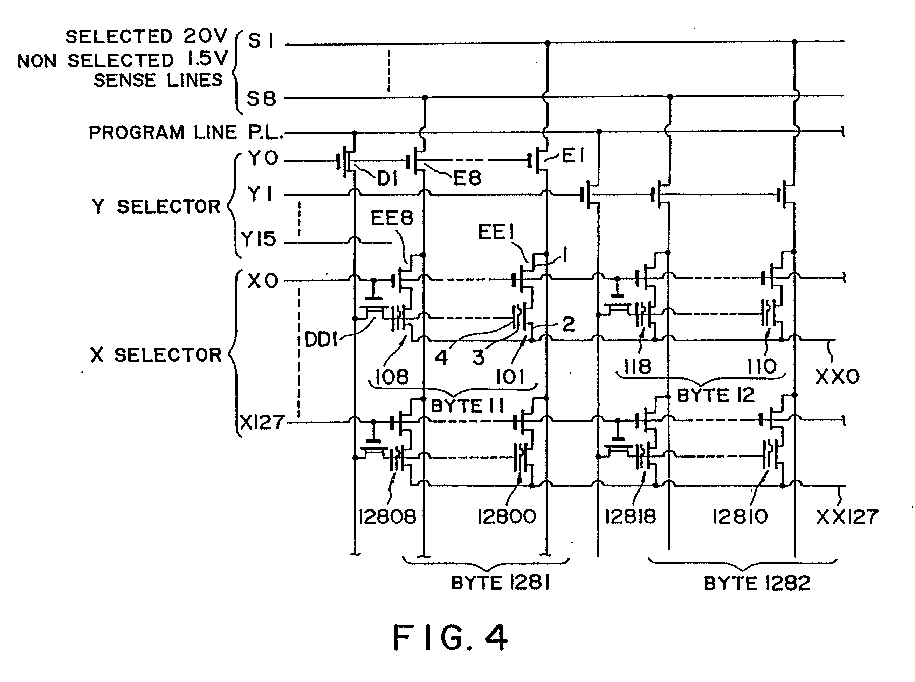

The way of applying a voltage in a more actual sense in this case will be described using FIG. 4 showing the configuration of memory cells. In this example, storage of data corresponding to one bit is carried out in one memory cell, and one byte is constituted by eight memory cells corresponding to eight bits. For example, one byte is constituted by memory cells of the first to eight bits. Such bytes are arranged in order of bytes 11, 12, 13, ... in a lateral direction, and are arranged in order of bytes 11, 21, 22, ... 1281. For example, the control gate 4 of the memory cell 101 is connected to other memory cells 101, 102, ..., 108 within the same byte 11, and is opened and closed by a depletion type transistor DD1. The drain 1 is supplied with power by an enhancement type transistor E1, and the source 2 is connected to a line XX0.

The gate of the transistor DD1 is opened and closed by a line X0 of an X selector connected to the select gate, and is supplied with power by a transistor D1 connected to a program line P.L. and having a gate opened and closed by a line Y0 of a Y selector. Furthermore, the gate of a transistor EE1 is opened and closed by the line X0 of the X selector. The transistor EE1 is supplied with a current by a transistor E1 connected to a sense line S1 and having a gate opened and closed by the line Y0 of the Y selector.

Programming to the memory cell assembly thus constructed is conducted as follows. First, electrons are injected into floating gates of all the memory cells of a selected byte. Then, electrons of only the selected memory cell thereof are extracted.

In the electron injection mode, assuming that e.g., a byte 11 is selected, sense lines S1 to S8 are all set to zero volts, the program line P.L. is placed at a program voltage (e.g., 20 volts), only the line Y0 and other lines of the Y selector are set to a program voltage and zero volts, respectively, and only line X0 and other lines of the X selector are set to a program voltage and zero volts, respectively.

Thus, the transistor D1 becomes conductive by the program line and the line Y0, and the transistor DD1 becomes conductive by the transistor D1 and the line X0. As a result, a program voltage is applied to all the control gates 4 of the memory cells 101 to 108. Since the sense lines S1 to S8 are at zero volts, the drain 1 of the memory transistor is kept at zero volts through transistors E1 to E8 and EE1 to EE8. Furthermore, the source 2 is set to zero volts by allowing the line XX0 to be grounded. Thus, electrons are injected into all the floating gates 3 of the memory cells 101 to 108.

The way of extracting electrons of the memory cell 101 of the first bit of the memory cells 101 to 108 will be conducted as follows. First, a program voltage is applied to only the sense line S1. While other sense lines S2 to S8 are all kept at zero volts in the prior art, a voltage of 1.5 volts is applied to the all other sense lines S2 to S8 in this embodiment. Furthermore, the program line P.L. is kept at zero volts, a program voltage is applied only to the line Y0 of the Y selector, other lines thereof are kept at zero volts, a program voltage is applied only to the line X0, and other lines X0 thereof are kept at zero volts. The source line XX0 is placed in a floating state or in the state where a voltage of about 5 volts is applied thereto.

Though the program line P.L. is at zero volt, the transistors D1 and DD1 become conductive because they are the depletion type transistors. As a result, the control gate 4 is kept at zero volts. When a program voltage is applied to the sense line S1, and the lines Y0 and X0, the transistors E1 and EE1 become conductive. Thus, a program voltage is applied to the drain 1 of the memory transistor of the memory cell 101 from which electrons are extracted. Furthermore, when a voltage of 1.5 volts is applied to the sense lines S2 to S8, and a program voltage is applied to the line Y0, transistor E2 to E8 become conductive. As a result of the fact that transistors EE2 to EE8 become conductive by application of a program voltage to the line X0, a voltage of 1.5 volts is applied to drains 1 of memory cells 102 to 108 from which no electron is extracted.

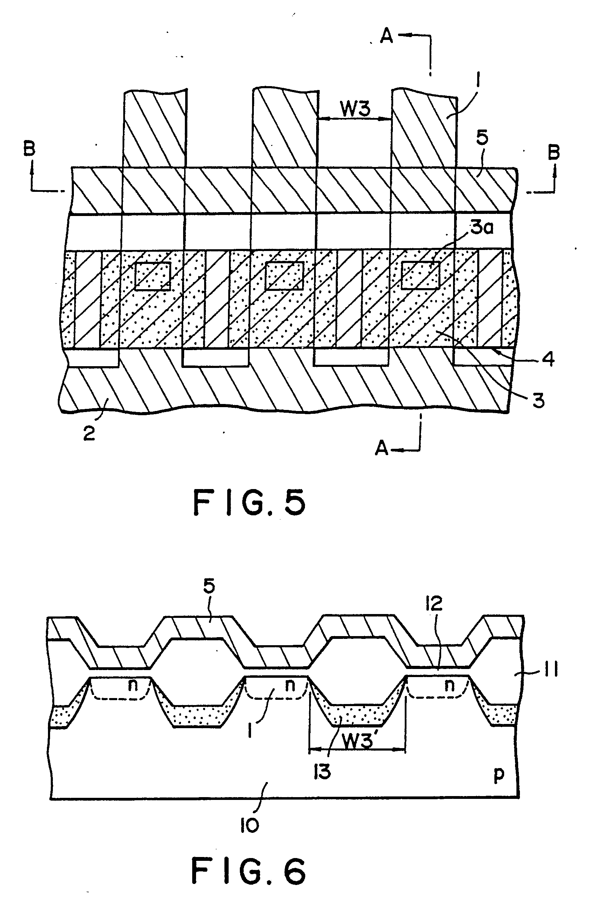

Thus, electrons of the floating gate 3 of only the memory cell 101 are extracted, whereas electrons of the floating gates 3 of other memory cells 102 to 108 are not extracted, so they are held in an injected state. Unlike the prior art as stated above, a voltage of 1.5 volts is applied to each drain of memory cells from which no electron is extracted. As a result, occurrence of a leak current from the drain 1a into the drain 1b is prevented. For this reason, as is clear from FIG. 5 of a plan view of a memory device to which this invention is applied and FIG. 6 of a cross sectional view taken along the A-A line of FIG. 5, an impurity layer having a high concentration is not required, but provision of only an impurity layer 13 having a low concentration is sufficient. In these figures, the same reference numerals are attached to the same components as those in FIGS. 1 and 3, respectively and their explanation will be omitted. By the programming method of this embodiment thus constructed, the distance W3 between drains 1 can be reduced to about 2 μm which is one half of the value of the prior art.

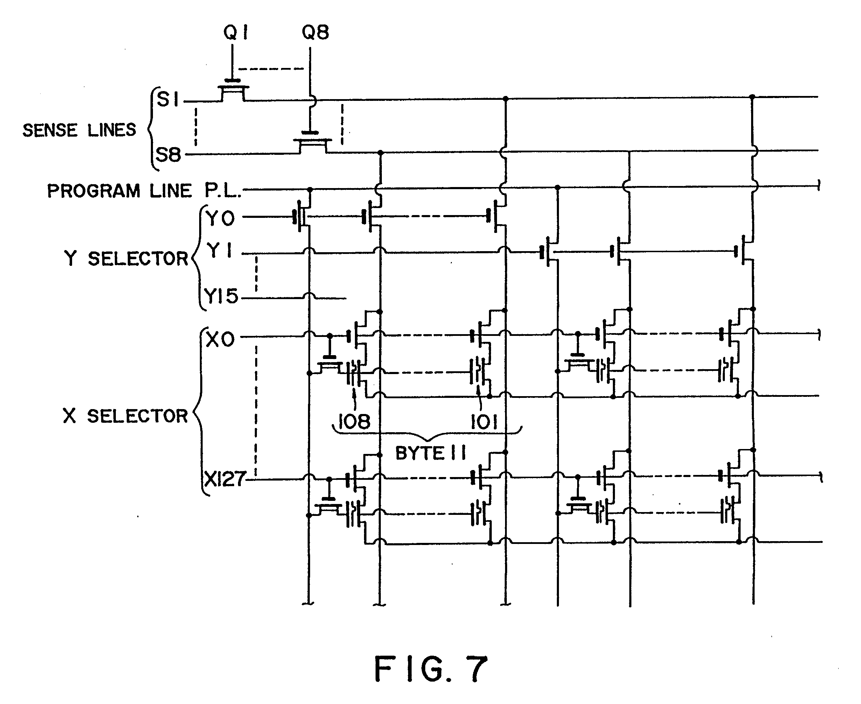

It is to be noted that the above-described embodiment is simply referred to as an example, but does not restrict this invention by any means. Namely, where bytes are arranged in a longitudinal direction as shown in FIG. 7, the select gate 5 is required in order to select respective lines X0, X1, ... X127. However, where only one byte is arranged, the select gate 5 is unnecessary.

Furthermore, the configuration of memory cells, and the way of applying a voltage to the floating gate, the select gate, the drain and the source of each memory cell may be different from that in FIG. 4. Furthermore, there may be employed a method of applying a voltage having the same polarity as that of a voltage applied to the select gate and lower than that voltage to the drain of each memory cell from which no electron is extracted. For example, in the case of the circuit configuration of a memory cell shown in FIG. 7, application of a voltage to the drain is made as follows.

In this example, transistors Q1 to Q8 which are the depletion type transistors are arranged in series on sense lines S1 to S8, respectively. Other elements are the same as those shown in FIG. 4. In this case, in the electron injection mode, sense lines S1 to S8 are all kept at zero volts or a positive voltage is applied to all the gates of the transistors Q1 to Q8. Therefore sense lines S1 to S8 are all kept at zero volts. Application of a voltage in other Y and X selectors is the same as that in the case shown in FIG. 4.

In the electron extraction mode, assuming now that only electrons of the memory cell 101 of the byte 11 are extracted and electrons of other memory cells 102 to 108 are not extracted, a program voltage is applied to all the sense lines S1 to S8, a program voltage is applied only to the transistor Q1, and zero volts are applied to other transistors Q2 to Q8. Thus, only the transistor Q1 become conductive, resulting in program voltage on the sense line S1. On the other hand, transistors Q2 to Q8 become off state, resulting in the state where a voltage of about 1.5 volts is applied thereto. As a result, in a manner similar to that in the case shown in FIG. 4, only the drain 1 of the memory cell 101 is kept at program voltage and a voltage of 1.5 volts is applied only to the drains 1 of the memory cells 102 to 108. By applying a voltage in this way, the same advantages as those described above can be provided.

Reference signs in the claims are intended for better understanding and shall not limit the scope.

## Claims

1. A programming method for a semiconductor memory device adapted to extract electrons injected into a floating gate (3) of a selected memory cell in a semiconductor memory device provided with two memory cells or more, each memory cell comprising a first impurity layer of a conductivity type opposite to a conductivity type of a semiconductor substrate (10) formed on the semiconductor substrate; a second impurity layer (2) of said opposite conductivity type formed on the surface of said semiconductor substrate with a predetermined spacing between said second and first impurity layers; a third impurity layer (6) of said opposite conductivity type formed between said first and second impurity layers, with predetermined spacings between said third and first impurity layers and between said third and second impurity layers, respectively; a select gate (5) formed through an insulating film on the surface of said semiconductor substrate between said first and third impurity layers; a control gate (4) formed through an insulating film above said third impurity layer; and a floating gate (3) buried in said insulating layer (7) so that it is positioned between said third impurity layer and said control gate and having a portion (3a) projected downwardly to thereby allow an insulating film portion between said floating gate and said third impurity layer to be thin and therefore form a tunnel portion (3a), characterized in that a program voltage is applied across a first impurity layer portion of each memory cell from which electrons are to be extracted to said third impurity layer and said control gate, and wherein a voltage having the same polarity as that of said program voltage and having an absolute value which is small to such an extent that field inversion can be prevented is applied across a first impurity layer portion of each memory cell from which no electron is extracted to said third impurity layer and said control gate.

2. A method as set forth in claim 1, wherein a voltage having a small absolute value applied across said first impurity layer and said control gate of said memory cells from which no electron is extracted is applied through a sense line.

FIG. 1    BACKGROUND ART

**F I G. 2** BACKGROUND ART

**F I G. 3** BACKGROUND ART

FIG. 4

EP 0 400 483 A2

F I G. 5

F I G. 6

F I G. 7